# EUROPEAN PATENT APPLICATION

(11) **EP 4 787 373 A1**
(43) Date of publication of application: **05.08.2026**
(21) Application number: 26153166.9
(22) Date of filing: 21.01.2026
(51) Int. Cl.: G11C 5/02, G11C 7/10, G11C 11/402

(54) **DISTRIBUTED COMPUTING IN A PACKAGE WITH DRAM DIES AND A LOGIC DIE**

(30) Priority: 29.01.2025 US 202563751122 P; 24.07.2025 US 202519279834
(71) Applicant: Samsung Electronics Co., Ltd., Suwon-si, Gyeonggi-do 16677 (KR)
(72) Inventor: WOO, Dong Hyuk, San Jose, CA 95134 (US); PARK, Hyunchul, San Jose, CA 95134 (US)
(74) Representative: Kuhnen & Wacker Patent- und Rechtsanwaltsbüro PartG mbB

(57) **Abstract**

A system and devices (100) are disclosed for implementing Compute with Memory Stack (CMS) semiconductor hardware (e.g., die, packages, etc.) with an architecture integrating memory and compute on a die, implementing shorter distance high-bandwidth communication between elements, and minimizing data traffic. A device (100) includes a first die (110), the first die (110) including a first compute component, a second compute component, a first set of Through Silicon Vias, TSVs, (152) associated with the first compute component and connecting stacked dies of the device (100), and a second set of TSVs (152) associated with the second compute component and connecting the stacked dies of the device (100). The device (100) includes a second die (115), stacked on the first die (110). The second die (115) may include a first memory bank module connected to the first compute component using the first set of TSVs (152), and a second memory bank module connected to the second compute component using the second set of TSVs (152).

## Description

### BACKGROUND

### 1. FIELD

Aspects of some embodiments of the present disclosure generally relate to semiconductor circuits. More particularly, the subject matter disclosed herein relates to a semiconductor microchip package implementing a distributed computing system including memory dies and a logic die designed for artificial intelligence (Al) operations and/or applications.

### 2. DESCRIPTION OF THE RELATED ART

High Bandwidth Memory (HBM) is a high-performance memory system of multiple three-dimensional (3D)-stacked dynamic random-access memory (DRAM) dies. Various applications such as deep neural networks and Artificial Intelligence (Al) may need massive computational and memory abilities to train on different datasets and learn with high accuracy. For such applications, high memory bandwidth may be desirable. Memory bandwidth can be described in terms of core bandwidth and bus bandwidth. As the number of stacked DRAM dies increases while sharing the same bus, bus bandwidth may become a limiting factor in memory performance.

The continued expansion of Al demands increasingly higher memory bandwidth and capacity. Attempts to scale memory bandwidth to be optimal for Al-based applications (e.g., increasing high-memory bandwidth for larger neural networks and/or more complex Al computations) using stacked HBM architecture may lead to various drawbacks. For example, there may be shoreline limitations (e.g., limited pin-count, etc.) and high power consumption associated with employing physically large stacked HBMs to scale memory bandwidth. Furthermore, large amounts of high-bandwidth data movement between the stacked DRAM dies and on-chip processing elements (e.g., logic die, host, etc.) may lead to increased energy consumption. Additionally, an architecture that implements logic in HBM core dies may provide compute processing capabilities but may threaten to exceed limitations on thermal budget associated with the dies and/or packages.

Thus, there is a desire for a flexible system architecture that leverages a standalone distributed compute system cop-packaged under DRAM dies to reduce or minimize data traffic (e.g., reducing power consumption, eliminate physical global bus) and maintain a thermal budget while performing computation in a manner that provides a high-bandwidth, energy-efficient memory subsystem that may be optimal for Al based applications.

The above information disclosed in this Background section is for enhancement of understanding of the context of the present disclosure, and therefore, it may contain information that does not constitute prior art.

### SUMMARY

Aspects of some embodiments of the present disclosure generally relate to Compute with Memory Stack (CMS) semiconductor hardware (e.g., die, packages, etc.) having an architecture that integrates memory and compute on a die, implements shorter distance high-bandwidth communication between elements, and minimizes data traffic. In some embodiments, a device may include a first die, the first die including a first compute component, a second compute component, a first set of Through Silicon Vias (TSVs) associated with the first compute component and connecting stacked dies of the device, and a second set of TSVs associated with the second compute component and connecting the stacked dies of the device. The device may include a second die, stacked on the first die. The second die may include a first memory bank module connected to the first compute component using the first set of TSVs, and a second memory bank module connected to the second compute component using the second set of TSVs.

In some embodiments, the device may additionally include a third die, stacked on the second die. The third die may include a third memory bank module connected to the first compute component using the first set of TSVs, and a fourth memory bank module connected to the second compute component using the second set of TSVs.

In some embodiments, the first memory bank module connected to the first compute component using the first set of TSVs may form a first processing element configured to perform a compute function utilizing data from the first memory bank module, and the second memory bank module connected to the second compute component using the second set of TSVs may form a second processing element configured to perform a compute function utilizing data from the second memory bank module.

In some embodiments, the device may further include a plurality of interconnected ports of the first die connecting the first processing element and the second processing element to one or more additional processing elements. The first compute component and the second compute component may include compute circuitry configured to perform the compute function and the one or more additional processing elements may include a compute component connected to at least one memory bank module from an array of memory bank modules arranged on the first die stacked thereon and using corresponding sets of TSVs.

In some embodiments, for the one or more additional processing elements, their respective compute components may be configured to perform a compute function on data from their respective at least one memory bank module that is stacked thereon.

In some embodiments, the device may additionally include a controller programmed to execute a transfer of the data between the first compute component and the first memory bank module, a transfer of the data between the second compute component and the second memory bank module, and for the one or more additional processing elements, a transfer of the data between their respective compute component and their respective at least one memory bank module.

In some embodiments, the first set of TSVs and the second set of TSVs may be among a plurality of TSVs distributed in a plurality of areas of the first die.

In some embodiments, the first set of TSVs may include at least one of the plurality of TSVs in a first area of the first die contacting the first compute component, the second set of TSVs may include at least one of the plurality of TSVs in a second area of the first die contacting the second compute component.

In some embodiments, the first processing element may additionally include the third memory bank module and may be configured to perform a compute function utilizing data from the third memory bank module, and the second processing element may additionally include the fourth memory bank module and may be configured to perform a compute function utilizing data from the fourth memory bank module.

In some embodiments, the stacked dies of the device may include a plurality of additional dies stacked on the third die.

In some embodiments, the device may additionally include Dynamic Random Access Memory (DRAM) dies, and one or more of the second die or the third die may include a DRAM die.

In some embodiments, the compute function may include one or more of: matrix multiplication; dot products; activation function; or a mathematical function associated with an Artificial Intelligence (AI) application.

In some embodiments, a device may include a first die, the first die may include a plurality of TSVs distributed in a plurality of areas of the first die, a first compute component, a second compute component, a first set of TSVs associated with the first compute component and connecting stacked dies of the device. The first set of TSVs may include one or more of the plurality of TSVs in a first area of the first die. The first die may include a second set of TSVs associated with the second compute component and connecting the stacked dies of the device. The second set of TSVs may include one or more of the plurality of TSVs in a second area of the first die different from the first area. The device may include a second die, stacked on the first die. The second die may include a first memory bank module connected to the first compute component using the first set of TSVs, and a second memory bank module connected to the second compute component using the second set of TSVs.

In some embodiments, the first memory bank module connected to the first compute component using the first set of TSVs may form a first processing element configured to perform a compute function utilizing data from the first memory bank module, and the second memory bank module connected to the second compute component using the second set of TSVs may form a second processing element configured to perform a compute function utilizing data from the second memory bank module.

In some embodiments, the stacked dies of the device may include a plurality of additional dies stacked on the second die.

In some embodiments, the device may additionally include DRAM dies, and one or more of the second die or the plurality of additional dies may include a DRAM die.

In some embodiments, the plurality of TSVs may be configured to transfer the data stored on the DRAM dies to the first die.

In some embodiments, the device may additionally include a plurality of interconnect ports on the first die configured for connecting the first processing element and the second processing element to a plurality of processing elements to implement a distributed computing system.

In some embodiments, a system may include an accelerator processor configured for performing a compute function. The accelerator processor may include a first die, the first die may include a first compute component, a second compute component, a first set of TSVs associated with the first compute component and connecting stacked dies of the device, and a second set of TSVs associated with the second compute component and connecting the stacked dies of the device. The accelerator processor may include a second die, stacked on the first die. The second die may include a first memory bank module connected to the first compute component using the first set of TSVs, and a second memory bank module connected to the second compute component using the second set of TSVs. The system may include memory storing instructions to be executed by the accelerator processor to perform the compute function.

### BRIEF DESCRIPTION OF THE DRAWING

In the following section, the aspects of the subject matter disclosed herein will be described with reference to exemplary embodiments illustrated in the figures.
FIG. 1A is a perspective view of an example compute with memory stack (CMS) device implementing a distributed computing system of processing elements depicted in FIG. 1B on a die, according to some embodiments of the present disclosure.
FIG. 1B depicts an example of a processing element having a microarchitecture that is included in the CMS device of FIG. 1A, according to some embodiments of the present disclosure.
FIG. 1C is a side view of the CMS device depicted in FIG. 1A, according to some embodiments of the present disclosure.
FIG. 2A is a plan view of the example CMS device depicted in FIG. 1A, according to some embodiments of the present disclosure.
FIG. 2B is a plan view of another example CMS device, according to some embodiments of the present disclosure.
FIG. 3 depicts another example CMS device having an architecture that includes a 4-hi stack of memory bank modules, according to some embodiments of the present disclosure.
FIG. 4 depicts another example CMS device having an architecture that includes an 8-hi stack of memory bank modules, according to some embodiments of the present disclosure.
FIG. 5 depicts another example CMS device having a multi-die package configuration including multiple CMS devices depicted in FIG. 3, according to some embodiments of the present disclosure.
FIG. 6 is a flow chart depicting example operations of a method for transferring data within the architecture of the CMS device of FIG. 1A, according to some embodiments of the present disclosure.
FIG. 7 is a block diagram of an example electronic device for implementing hardware of the CMS device depicted in FIG. 1A, according to some embodiments of the present disclosure.

### DETAILED DESCRIPTION

In the following detailed description, numerous specific details are set forth in order to provide a thorough understanding of the disclosure. It will be understood, however, by those skilled in the art that the disclosed aspects may be practiced without these specific details. In other instances, well-known methods, procedures, components and circuits have not been described in detail to not obscure the subject matter disclosed herein.

Reference throughout this specification to "one embodiment" or "an embodiment" means that a particular feature, structure, or characteristic described in connection with the embodiment may be included in at least one embodiment disclosed herein. Thus, the appearances of the phrases "in one embodiment" or "in an embodiment" or "according to one embodiment" (or other phrases having similar import) in various places throughout this specification may not necessarily all be referring to the same embodiment. Furthermore, the particular features, structures or characteristics may be combined in any suitable manner in some embodiments (e.g., in one or more embodiments). In this regard, as used herein, the word "exemplary" means "serving as an example, instance, or illustration." Any embodiment described herein as "exemplary" is not to be construed as necessarily preferred or advantageous over other embodiments. Additionally, the particular features, structures, or characteristics may be combined in any suitable manner in one or more embodiments. Also, depending on the context of discussion herein, a singular term may include the corresponding plural forms and a plural term may include the corresponding singular form. Similarly, a hyphenated term (e.g., "two-dimensional," "predetermined," "pixel-specific," etc.) may be occasionally interchangeably used with a corresponding non-hyphenated version (e.g., "two dimensional," "predetermined," "pixel specific," etc.), and a capitalized entry (e.g., "Counter Clock," "Row Select," "PIXOUT," etc.) may be interchangeably used with a corresponding non-capitalized version (e.g., "counter clock," "row select," "pixout," etc.). Such occasional interchangeable uses shall not be considered inconsistent with each other.

Also, depending on the context of discussion herein, a singular term may include the corresponding plural forms and a plural term may include the corresponding singular form. It is further noted that various figures (including component diagrams) shown and discussed herein are for illustrative purpose only, and are not drawn to scale. For example, the dimensions of some of the elements may be exaggerated relative to other elements for clarity. Further, if considered appropriate, reference numerals have been repeated among the figures to indicate corresponding and/or analogous elements.

The terminology used herein is for the purpose of describing some example embodiments only and is not intended to be limiting of the claimed subject matter. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that when an element or layer is referred to as being on, "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

The terms "first," "second," etc., as used herein, are used as labels for nouns that they precede, and do not imply any type of ordering (e.g., spatial, temporal, logical, etc.) unless explicitly defined as such. Furthermore, the same reference numerals may be used across two or more figures to refer to parts, components, blocks, circuits, units, or modules having the same or similar functionality. Such usage is, however, for simplicity of illustration and ease of discussion only; it does not imply that the construction or architectural details of such components or units are the same across all embodiments or such commonly-referenced parts/modules are the only way to implement some of the example embodiments disclosed herein.

Unless otherwise defined, all terms (including technical and scientific terms) used herein have the same meaning as commonly understood by one of ordinary skill in the art to which this subject matter belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein, the term "module" refers to any combination of software, firmware and/or hardware configured to provide the functionality described herein in connection with a module. For example, software may be embodied as a software package, code and/or instruction set or instructions, and the term "hardware," as used in any implementation described herein, may include, for example, singly or in any combination, an assembly, hardwired circuitry, programmable circuitry, state machine circuitry, and/or firmware that stores instructions executed by programmable circuitry. The modules may, collectively or individually, be embodied as circuitry that forms part of a larger system, for example, but not limited to, an integrated circuit (IC), system on-a-chip (SoC), an assembly, and so forth.

In the realm of computer technologies, Al and other deep learning applications are becoming more common and are presently in high demand. With the growth of Al computing applications, new hardware may be required to enable new applications in domains spanning image and speech classification, media analytics, healthcare, autonomous machines, and smart assistants. In deep neural network algorithms, for example, the size of the data set may outgrow the computational abilities of the hardware available. Furthermore, as emerging Al applications become more expansive and complex, massive computational and memory capabilities are needed to train on different datasets and learn with high accuracy. Furthermore, as applications like high performance computers (HPC), graphics algorithms, and the like, become data and compute intensive, energy-efficiency and low latency may become more desirable.

Some server computer environments may utilize a configuration that enables some computation to be performed physically closer to where the data resides. By implementing data movement over a relatively shorter distance, higher bandwidth and reduced energy consumption may be achieved for computing systems performing higher complex computations, such as Al applications. An example of a hardware architecture that may be modified to supports computation (or logic) near memory is High Bandwidth Memory (HBM). HBM is a type of computer memory designed for high-speed data transfer, achieved through a stacked architecture of memory chips. For example, an HBM is a high-performance memory including Dynamic Random Access Memory (DRAM) dies stacked one atop another in a manner that achieves higher bandwidth while using less power in a smaller form factor.

An evolution of HBM, High Bandwidth Memory 2 (HBM2), may include, for example, up to 12 dies per stack and provide pin transfer rates of 2.4 GT/s (giga transfers per second) or faster. HBM and HBM2 have been used to implement hardware, such as parallel accelerators, which provides the high-bandwidth, high capacity, and computational abilities that may be required for Al applications. Further versions of HBM (E.G., HBM3, HBM3e, HBM4, etc.) may provide higher memory capacities, larger transfer rates, and more stacked DRAM dies. For simplicity, all versions of HBM are simply referred to herein as "HBM."

HBM provides high-capacity memory through the stacked memory chips, however, computations in the architecture are performed by a host or other external chip. A host may include, for example, a central processing unit (CPU) such as a microprocessor, an application specific integrated circuit (ASIC), a graphics processing unit (GPU), a field-programmable gate array (FPGA), and/or the like. Accordingly, HBMs utilize an asynchronous communication interface with a host. For example, in an HBM architecture, the multiple stacked DRAM dies may be configured to share a global physical bus to support data movement between the memory elements to the compute elements (e.g., memory-utilizing component), such as the host.

For higher HBM stack configurations (e.g., 8 stacked DRAM dies, 12 stacked DRAM dies, etc.) the bandwidth utilization of the memory bus may be increasingly important. With respect to complex functions, such as Al and HPC, significant amounts of computational power and memory bandwidth may be required, which may further increase the importance of bandwidth utilization of the bus in the HBM architecture in these applications. As demands upon memory bandwidth increase, due to factors like increasingly powerful GPUs, the HBM architecture may not fully take advantage of the bus bandwidth. Additionally, the asynchronous nature of the communications on the global bus may increase performance but also makes it more difficult to process complex logic operations. Moreover, as the HBM architecture requires movement of data between the stacked DRAM dies and the host (e.g., compute), the transfer of high bandwidth data over a relatively long distance may increase the power consumption in HBM systems.

To address these and other limitations associated with some memory architectures, embodiments disclosed herein provide Compute with Memory Stack (CMS) semiconductor hardware (e.g., die, packages, etc.) having a distinct architecture that integrates memory and compute on a single die, implements shorter distance high-bandwidth communication between elements, and minimizes data traffic. Thus, CMS hardware, as disclosed herein, may provide a memory device with increasingly high-bandwidth, increased capacity, and high energy-efficiency that is optimized for complex processing functions, such as Al applications.

The disclosed CMS hardware architecture may implement a die including a memory layer configured to support high bandwidth memory and a compute layer configured for implementing logic and/or compute functions that is arranged adjacent to (e.g., beneath) the memory layer. The memory layer and the compute layer may be interconnected (e.g., physically and/or communicatively connected) using vias, such as Through-Silicon Vias (TSVs), that are distributed throughout the die in a manner that supports compute functions and/or capabilities implemented proximately to memory on the die and eliminates the use of a global physical bus (e.g., required in HBM architectures). In one or more embodiments, the memory layer of the CMS architecture may include one or more stacked "layers" of memory bank modules. In one or more embodiments, the stacked memory bank modules in the memory layer of the HBM with Compute (HBMC) hardware architecture may be implement as stacked DRAM dies. Accordingly, the CMS hardware architecture, as disclosed herein, may implement an integrated high-bandwidth memory and active compute device, rather than a passive memory device (e.g., does not require a separate host for processing like existing HBM architectures). The disclosed CMS hardware may realize several advantages, as disclosed herein, such as enhancing speed and performance for data processing tasks by eliminating the latency of transferring data (e.g., communicating to a separate compute SoC, delay associated with a global bus, etc.), enabling real-time analysis and faster decision-making which can increase the overall efficiency of hardware utilized in complex Al applications.

In one or more embodiments, the CMS hardware architecture may be implemented using various configurations. For example, a CMS die may be configured to include a varying number of multiple stacked memory bank modules. Also, in one or more embodiments, a CMS hardware architecture may provide a semiconductor package that can include a varying number of multiple interconnected CMS dies in a manner that supports a wide range of bandwidth and/or capacity capabilities for memory. Therefore, the embodiments disclosed herein provide a flexible and/or adaptable CMS hardware architecture that enables the memory and active compute device to be scaled and/or optimized as desired to adequately support a particular Al application.

Additionally, embodiments disclosed herein may provide a processing element that may serve as the "building block" for a larger architecture of the CMS hardware. For example, a CMS die may include an array of processing elements (e.g., multiple processing elements are interconnected on die via interconnect ports), where the size and/or dimensions of the array may be flexibly adjusted to be scaled and/or optimized based on the applicable Al functions. In one or more embodiments, the processing element may have a microarchitecture that includes at least one memory bank module, and compute logic that is arranged under the memory bank module and having a form factor that is substantially similar to the memory bank module in a manner that supports processing capabilities that are proximate to memory (e.g., memory bank module) while minimizing data traffic and operating within an appropriate thermal budget. The microarchitecture for the processing element is also described herein with respect to the framework of the CMS hardware.

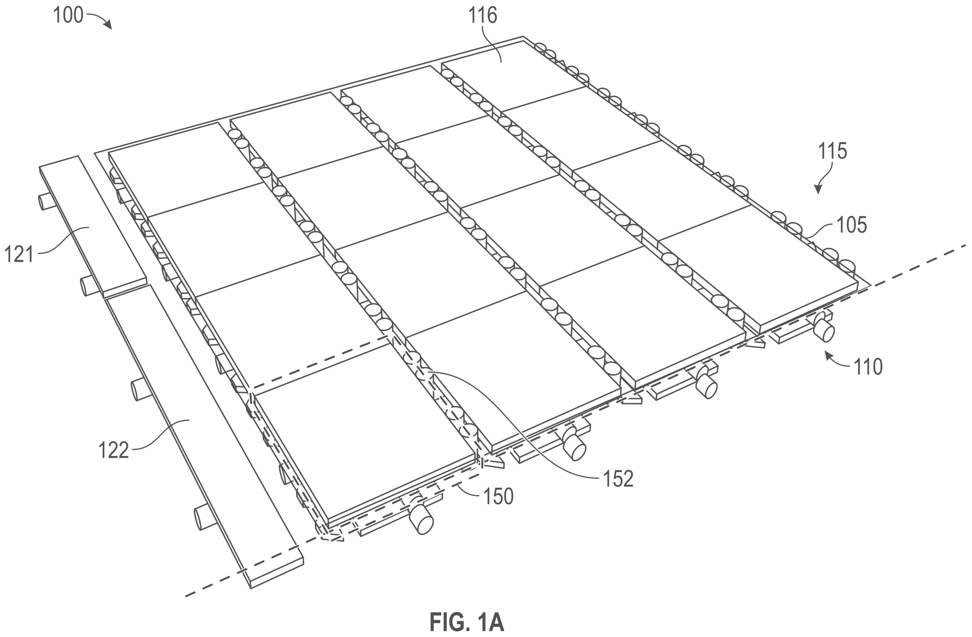

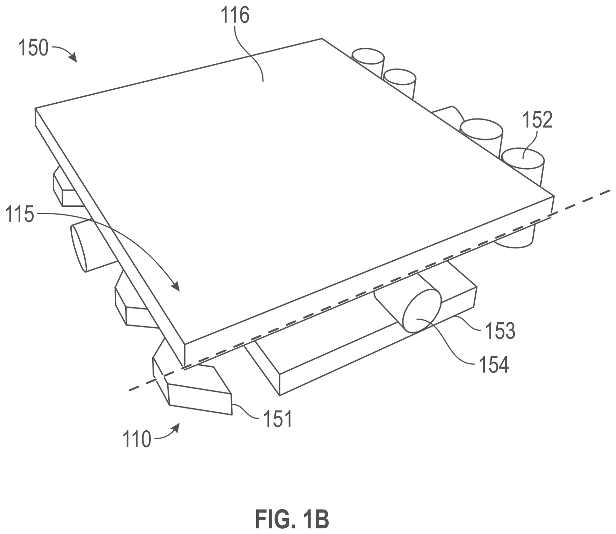

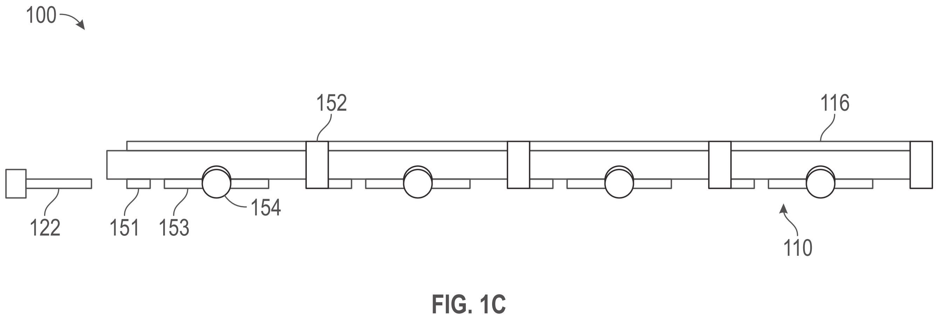

FIG. 1A is a perspective view of an example of CMS device 100, as disclosed herein. In the example of FIG. 1A, the architecture of the CMS device 100 implements integrated high-bandwidth memory and compute functions and/or capabilities on the hardware of a semiconductor die 105. FIG. 1C is a side view of the CMS device 100 depicted in FIG. 1A, according to some embodiments of the present disclosure. As used herein, "die" may refer to a semiconductor device that contains functional circuitry and/or integrated circuit (IC) for executing functions that may be created (e.g., monolithically produced) on a wafer of semiconductor material, such as silicon. In the architecture of the CMS device 100, the die 105 may be arranged as a "base die" (also referred to as a "first die") that can be positioned at a lower layer (e.g., bottom) of the architecture and implementing the compute layer 110 (and compute components therein). As the base die, the die 105 can have one or more additional dies that are arranged adjacently thereon (e.g., memory modules 116 implemented as memory dies stacked on the die 105 at the base). In one or more embodiments, the architecture for the CMS device (CMS hardware) 100 can be described as comprising an N x N (or N X M) array of smaller processing elements 150. The microarchitecture of the processing elements 150 is described in greater detail in reference to FIG. 1B. As depicted in FIG. 1A, the example CMS device 100 may be configured as a 4 x 4 array of processing elements 150 implemented utilizing die 105 at the base die (although other array dimensions may be utilized). FIG. 1A depicts that the example architecture for the CMS device 100 can include two layers (indicated by the horizontal dashed line) that may be a compute layer 110 that is implemented on the die 105 (e.g., die 105 is the base die that includes the compute components (including compute circuitry 151 of the compute layer 110), and a memory layer 115 that is physically arranged adjacent to (e.g., on top of) compute layer 110 and connected thereto using a plurality of vias, shown as TSVs 152, that are distributed throughout the die 105, and external components 121 and 122 Thus, each processing element 150 in the array may have a memory layer 115 (including memory modules 116), a compute layer 110 (including compute components corresponding to the particular memory module 116 stacked thereon), and associated TSVs 152 arranged (connecting the compute components to the corresponding memory module stacked thereon) in a manner that provides a memory and compute component to each processing element 150 of the array. In other words, the compute layer 110, implemented on the die 105 (base die) adjacent to (underneath) the memory layer 115, includes compute components that are configured to perform a compute function on data transferred from the memory layer 115, and particularly from the corresponding memory bank module 116 that is stacked thereon. Each of the layers, the compute layer 110 and the memory layer 115, may be implemented as a respective die (e.g., each die produced from a single wafer), and thus the CMS device 100 can include multiple adjacent, or stacked, dies. In the example of FIG. 1A, a die implementing the memory layer 115 may be divided into an array of separate memory bank modules 116 that are directly accessible to the compute elements that are arranged adjacent (e.g., directly below) to them in the compute layer 110, where the lower compute layer 110 is implemented by die 105 at the base.

The CMS device 100 includes a plurality of TSVs 152 distributed in multiple areas throughout the die 105 in a manner that provides physical and/or communication connections between the plurality of processing elements 150, and directly interconnects the compute layer 110 and the memory layer 115 of each processing element 150 to support compute functions. The TSVs 152 are positioned vertically between the individual elements of the compute layer 110 and the memory layer 115 enabling a "vertical" communication that may be directly between the separate memory bank modules 116 and the compute element(s) that are arranged underneath in the compute layer 110 (e.g., a memory bank module 116 is stacked on top of corresponding compute elements) in each of the processing elements 150. For example, the CMS device 100 may have an architecture that includes the die 105 as a first die (e.g., arranged at the base, lower layer of the architecture) implementing the compute layer 110, and at least a second die, arranged on the first die (e.g., one or more additional dies stacked on top of the die 105), that implements the memory layer 115. The first die maty include a plurality of TSVs 152 that are distributed throughout (e.g., separate sets of TSVs 152 are arranged in different areas/sections of the die 105), and at least a first compute component and a second compute component (e.g., corresponding to two individual processing elements 150 in the array) that are implemented on the first die (in the compute layer 110 of the architecture). The second die may include at least a first memory bank module 116 and a second memory bank module 116 (e.g., corresponding to two individual processing elements 150 in the array). The first memory bank module may be connected to the first compute component using a first set of TSVs 152 that are associated with the first compute component. For example, the first set of TSVs 152 may be associated with the first compute component by being more proximately located (e.g., contacting, connected, etc.) to the first compute component. The second memory bank module may be connected to the second compute component using a second set of TSVs 152 that are associated with the second compute component. For example, the second set of TSVs 152 may be associated with the second compute component by being more proximately located (e.g., contacting, connected, etc.) to the second compute component. The second set of TSVs that are associated with the second compute components may be different from the TSVs 152 that correspond to the first set of TSVs 152. Accordingly, the TSVs 152 are configured to transfer data between the die 105 at the lower, compute layer 110 of the architecture to at least the second die that may be stacked thereon in the higher, memory layer 115 of the architecture (e.g., data stored on the memory bank module 116 transferred to the corresponding compute components arranged underneath), where a set of TSVs 152 function respectively for each of the individual processing elements 150 (and components thereof).

Furthermore, by arranging processing elements 150 within the array, in such a way that a plurality of interconnect ports 154 in the die 105 (base die) are positioned horizontally between the multiple processing elements 150, physical and/or communication connections between the plurality of processing elements 150 may be provided which enables the CMS device 100 to function as a network of distributed nodes (e.g., each node having memory and compute functions) having the die 105 as a base die. Although FIG. 1A illustrates the CMS device 100 configured as a 4 x 4 array of processing elements 150 implemented on die 105 (base die), embodiments according to the present disclosure are not limited thereto, and according to various embodiments, additional (or fewer) processing elements 150 may be included (e.g., as a larger array and/or with additional layers of the processing elements 150). Also, according to various embodiments, additional memory layers 115 (e.g., 8, 12, 16, 24, 32, etc.) may be included in the architecture of the CMS device 100, being implemented as additional dies (arranged on top of the die 105 at the base), as disclosed herein.

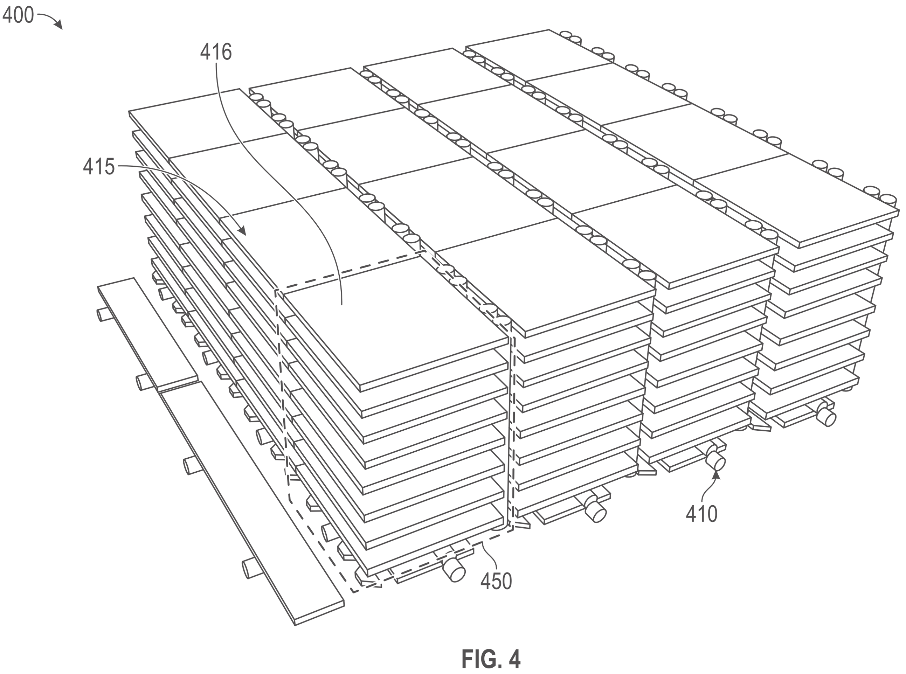

In one or more embodiments, the configuration of the die 105 (e.g., base die and the higher layer elements implemented thereon) may be considered as the "core" CMS die design for the various CMS devices and/or hardware architectures that are disclosed herein. That is, the die 105 may be used as a "core" stand-alone module that can be repeatably connected to ultimately assemble the relatively larger and/or more complex CMS devices and/or hardware architectures. For instance, the examples of CMS devices depicted in more detail below in FIG. 4 to FIG. 6 may have architectures that include multiple modularly repeated CMS "core" dies 105 in variously configured larger assemblies. Thus, in one or more embodiments, the die 105 may be mounted on a circuit board with other circuitry, external components, and/or semiconductor devices to form the CMS device 100. In some embodiments, the CMS device 100 may be implemented as a hardware device, or a combination of hardware and/or software components. In some embodiments, the die 105 may be included in a semiconductor microchip and/or semiconductor package that may include additional dies, circuitry, external components, semiconductor devices, external pins, pads, electrical connections, and/or the like that may be encased in a protective package. In one or more embodiments, the die 105 may include additional circuitry to support aspects and/or functions of the memory layer 115 and/or the compute layer 110. In one or more embodiments, the CMS device 100 may be implemented as a high-bandwidth and/or high-efficiency hardware component of a computer processor, such as a CPU, GPU, NPU, and/or accelerator processor. For example, an example of the CMS device 100 implementing an accelerator processor is described in greater detail in reference to FIG. 8, which may be utilized in data-intensive tasks including Al applications.

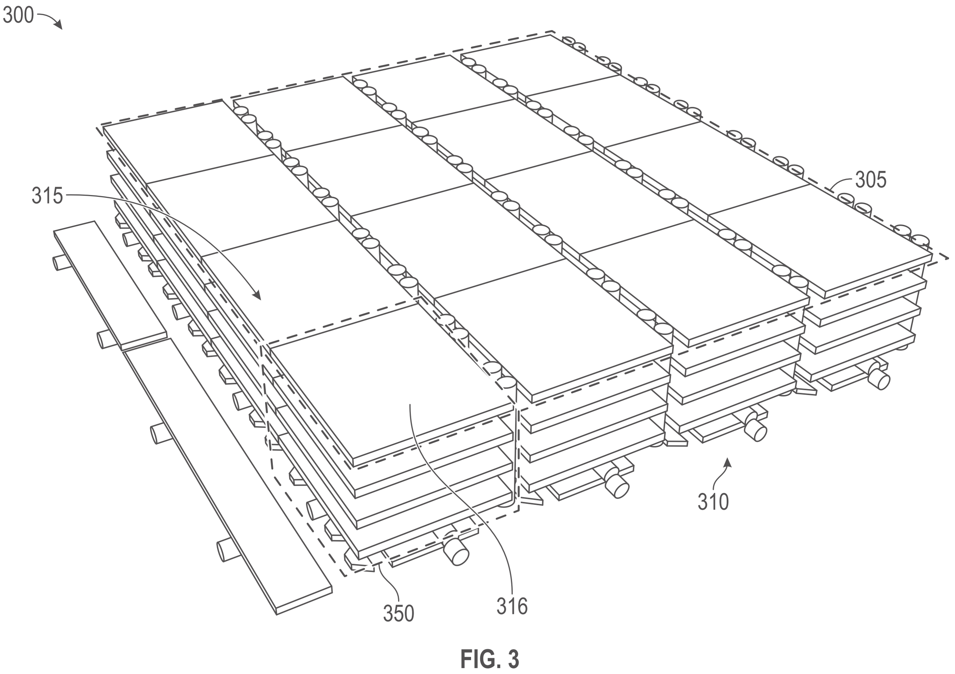

The memory layer 115 may be configured to include circuitry for a plurality of memory bank modules 116. As referred to herein, a "memory bank module" may refer to physical circuitry and/or a logical unit of memory on hardware, such as a die, allowing for parallel access and operation on data, which enables high-bandwidth and high-capacity memory capabilities, as disclosed herein. As illustrated in FIG. 1A, the (hardware) memory layer 115 may be organized as an array of memory bank modules 116 such that the memory bank modules 116 can be accessed concurrently, enabling faster data transfer rates. The CMS device 100 in FIG. 1A may be configured as a 4 x 4 array of memory "banks", where there are a total number of 16 memory bank modules 116 implemented on the die 105. Stated another way, the CMS device 100 in FIG. 1A may be configured as a 4 x 4 array of processing elements 150, where each processing element 150 may be configured to include a corresponding memory bank module 116 implemented thereon. In one or more embodiments, the architecture of an CMS device may be made flexible and/or scalable by implementing a varying number of stacked memory bank modules 116 in the memory layer 115. For example, FIG. 3 depicts another example of an CMS device 300 where the memory layer 310 is distinctly configured to include a 4-hi memory bank stack, where there are four memory bank modules 316 that are vertically stacked per processing element 350 in a manner that may provide increased memory bandwidth and/or capacity in comparison to the CMS device 100 ("single memory stack" HBMC device 100) implemented in FIG. 1A. In one or more embodiments, the memory banks modules 316 may be implemented as a DRAM die. Accordingly, a 4-hi memory bank stack may be implemented as four DRAM dies vertically stacked on top of each other. Although one or more example embodiments of the present disclosure have been described in reference to CMS device architectures, those skilled in the art will readily appreciate that many modifications are possible in the example embodiments without materially departing from the aspects of the present disclosure. Accordingly, all such modifications, for examples adaptations to the number of vertically stacked DRAM die (e.g., greater and/or fewer layers of memory) that may be implemented in a CMS hardware architecture, are intended to be included within the scope of the present disclosure.

As will be described in greater detail herein, FIG. 4 to FIG. 6 depict examples of different CMS device architectures, where the varying configurations (e.g., different number of memory bank stacks and/or number of die) of the CMS device may enable the hardware to be adapted and/or optimized to provide desired memory and/or compute capabilities as deemed necessary and/or appropriate, for instance based on an Al application.

Referring again to FIG. 1A, the memory layer 115 may be arranged adjacent to (e.g., on top of) the compute layer 110 on the die 105 at the base, and the memory layer 115 may be physically and/or communicatively connected to the compute layer 110 using vias, shown as TSVs 152. As previously described, the architecture of the example CMS device 100 (HBMC device) 100 may be configured as a 4 x 4 array of multiple processing elements 150. Each processing element 150 may have corresponding vertical connections (e.g., interconnecting the memory layer 115 and the compute layer 110) using TSVs 152, and thus by arranging multiple connected processing elements 150 utilizing the die 105 as the base die, a plurality of TSVs 152 may be distributed throughout multiple regions of the die 105 (e.g., as opposed to TSVs position in a centralized region of a die). An aspect of the CMS device 100 and/or hardware architecture, as disclosed herein, may involve distributing the plurality of TSVs 152 throughout the die configuration. By implementing multiple processing elements 150 (e.g., including corresponding compute and stacked DRAM) on a die, for example die 105, the architecture may include multiple TSV regions that are dispersed throughout various regions of the die's area (rather than arranging all TSVs centrally on the die). Accordingly, the disclosed CMS hardware leverages a distinct arrangement of TSVs 152, being distributed thought the die 105 (or multiple stacked die) in order to implement short-distance high-bandwidth interconnections between stacked memory bank modules 116 and the underlying compute modules (in the compute layer 110) in a manner that may reduce power consumption and may mitigate the need for a global physical bus and/or global addressability. Also, each processing element 150 may have corresponding horizontal connections (e.g., interconnecting the plurality of the processing elements 150 on the die 105) using interconnect ports 154. Thus, the plurality of processing elements 150 within the 4 x 4 array may have physical and/or communication connections therebetween by utilizing the distributed TSVs 152, interconnect ports 154, and software (e.g., as opposed to a global physical bus) to support the transfer and/or communication of data between the distributed network of processing elements 150 on the die 105. Accordingly, the compute layer 110 may be comprised of the compute components that are within the processing element 150 "building block" for the hardware, which is repeated 16 times on the die 105. This may be referred to as an array of building blocks or an array of processing element building blocks. In other words, in the example of FIG. 1A, each of the 16 processing elements 150 in the 4 X 4 array has a memory bank module 116 (within the memory layer 115) on top of and corresponding to compute components that are disposed directly underneath of the memory bank module 116 (within the compute layer 110) on the die 105. and stacked thereon to correspond to the memory bank module. While the array of 16 building blocks is depicted in FIG. 1A, the present disclosure is not limited thereto, and the array may include more or less number of building blocks, such as, for example, 6, 8, 9, 12 or 25 building blocks. Details regarding the structure and function of compute components that may be included in a processing element 150 are described in more detail with reference to FIG. 1B. In one or more embodiments, the compute layer 110 may be implemented as a logic die. Accordingly, in one or more embodiments, the CMS device 100 may be implemented including a stack of DRAM dies one atop another, and a logic die disposed beneath the DRAM die stack.

The compute layer 110 may be configured to include compute circuitry to implement compute functions, processing, and/or computational related capabilities which enables the CMS device 100 to function as a high-bandwidth memory and active compute device. The compute layer 110 may be configured to implement various capabilities that are the same as (or substantially similar to) the functions of a memory-utilizing component, including, but not limited to: a host; a CPU; a GPU; a NPU; an ASIC, an FPGA; and/or the like. For example, the compute circuitry of the compute layer 110 may be configured to receive data from the memory layer 115 and perform general or specialized logic functions on the data, which may be specific to machine learning and/or Al applications that can have special high-bandwidth requirements. In one or more embodiments, the compute layer 110 may be configured to perform basic input/output (I/O) operations, and/or control operations related to communication and/or data transfer with other elements, for example the memory bank modules 116.

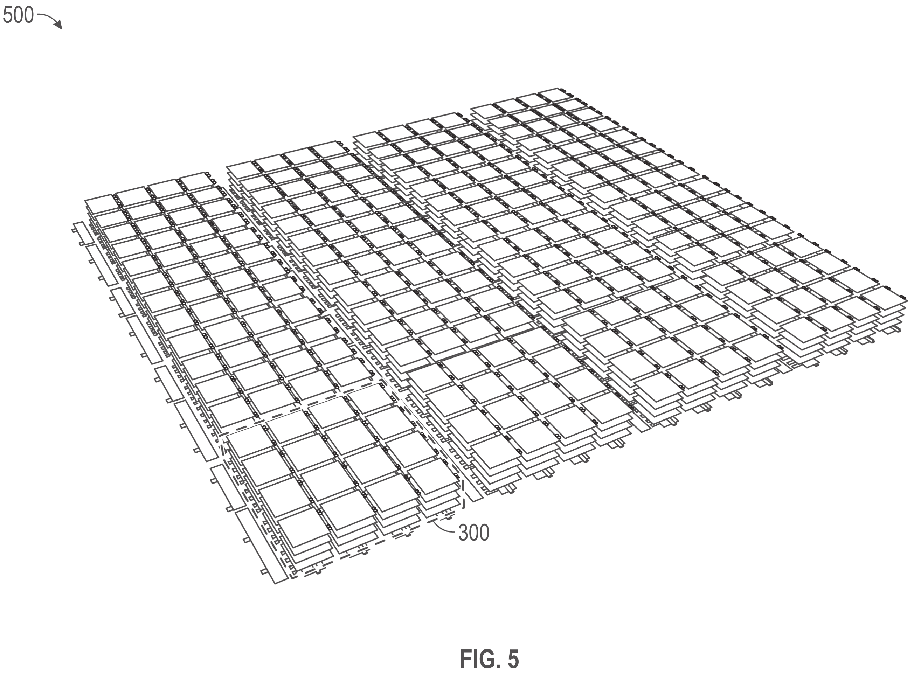

Additionally, the compute layer 110 may include a plurality of interconnect ports 154 which provides physical and/or communication connections between the multiple processing elements 150 on the die 105. For example, each processing element 150 is configured to include one or more interconnect ports 154 that may be utilized as a "horizontal" connection to a neighboring processing element 150 in the example 4 x 4 array configuration. By arranging multiple processing elements 150 (each processing element 150 having corresponding interconnect ports 154) in the array, a mesh network of interconnect ports 154 between the processing elements 150 may be distributed in the compute layer 110, enabling communication between each of the processing elements 150 (e.g., nodes in the mesh network) in the array. The network of interconnect ports 154 on the die 105 (distributed in the compute layer 110) may allow the plurality of processing elements 150 to communicate with each other on die 105 (and with connected devices) forming a unified "compute network" system of multiple processing elements 150 to collectively implement compute functions, processing, and/or computational related capabilities. In one or more embodiments, the compute layer 110 may include a plurality of interconnect ports (ingress/egress inter-die ports) 154 that may be configured as horizontal electrical connections between processing elements 150 that may be distributed across separate dies. For example, one or more interconnect ports 154 that are arranged on die 105 may be connected to other processing elements 150 that are implemented on a separate and adjacent die (e.g., in a multi-die package in FIG. 5). The interconnect ports 154 may provide a physical and/or communication interconnect for the processing elements 150 on die 105 and other dies in a manner that supports inter-die communication that may be involved in a larger scale multi-die distributed processing system.

As seen in FIG. 1A, the hardware architecture of the CMS device 100 places the compute components (within the compute layer 110) physically adjacent (e.g., beneath) and proximate to the associated memory components (within the memory layer 115) on the die 105, which decreases the distance related to the transfer of data on the to perform compute functions. The CMS device 100 leverages the distinct architecture which implements an active compute layer 110 under the memory layer 115, thereby providing processor-near-memory capabilities that may improve memory bandwidth and performance of specialized hardware, such as machine learning accelerators, while lowering energy consumption associated with the die 105. Machine learning and/or Al-based algorithms may benefit from lower latency and improved memory traffic realized by the architecture of the CMS device 100, as these applications can require intensive bandwidth and compute efficiency for training and prediction.

FIG. 1A illustrates that the CMS device 100 may include components that are connected to the die 105 and implement aspects and/or functions related to the high-bandwidth memory and/or compute capabilities of the CMS device 100. In the example, the components may include a controller 121 and an input/output interface 122. The controller 121 may be configured to perform functions (which may include functional fallback) related to the control of system 100, and additional compute, (e.g., high-precision math) operations that may be implemented by the CMS device 100. In one or more embodiments, the controller 121 may be configured to utilize Reduced Instruction Set Computing (RISC)-V to perform the basic operations and control the behavior of the CMS device 100 hardware and/or software, such as executing instructions and/or processing data. In one or more embodiments, the controller 121 may be implemented as a processor, microprocessor, CPU, and/or the like for the die 105.

The input/output (I/O) interface 122 may be configured to implement functions related to interfacing with the data and/or components on the die 105 in a manner that enables efficient communication between the die 105 and peripheral device that may be connected to the die 105. In one or more embodiments, the I/O interface 122 can be configured to implement encryption/description, ASIC related functions (e.g., protecting model IP, user privacy, and/or specialized/application specific end-user programs), specialized I/O related functions, and/or the like. In one or more embodiments, the I/O interface 122 may be implement as a Peripheral Component Interconnect Express (PCle) interface and the circuitry of the CMS device 100 (HBMC device) 100 can be implemented on a PCI-E compatible board.

FIG. 1B depicts an example microarchitecture for the processing element 150. As seen in FIG. 1B, the processing element 150 may be configured to include one or more components in the microarchitecture, including but not limited to: a memory bank module 116; compute circuitry 151; TSVs 152; static memory 153; and interconnect port(s) 154. As used herein, the term "compute" and/or "compute circuitry" may refer to computational hardware resources (e.g., circuits, IC modules, logic units, CPUs, GPUs, specialized hardware, etc.) that can be utilized in computation, such as training, retraining, and/or running Al models and/or algorithms.

The memory bank module 116 may be implemented as a form of dynamic-state volatile computer memory that utilizes power to maintain data and has a relatively high capacity and/or speed, as deemed suitable to provide high-bandwidth memory and data storage capabilities for the CMS device 100. The memory bank module 116 may be implemented as DRAM, static random-access memory (SRAM), Magnetoresistive Random Access Memory (MRAM), or other volatile or non-volatile memories, memory cell(s), circuitry, and/or other memory components as deemed suitable and/or appropriate to be arranged in a bank, array, and/or stacked memory configuration. In one or more embodiments, the memory bank module 116 is implemented as a DRAM die. According, in one or more embodiments, a stack of memory bank modules 116 in the memory layer 115 may be implemented as multiple vertically stacked DRAM dies.

As previously described, the microarchitecture of the processing element 150 may also be described as having a memory layer 115 and a compute layer 110 that is disposed adjacent to (e.g., underneath of) the memory layer 115. The compute layer 110 of the processing element 150 can include several components, including the compute circuitry 151, TSVs 152, the static memory 153; and interconnect port(s) 154, that may function together to implement a distributed computing system that is directly below the stack of memory bank modules 116 in the memory layer 115.

The compute circuitry 151 may be circuitry that is configured to implement the compute functions and/or capabilities for the CMS device 100. As alluded to above, the computational operations and/or functions executed by compute circuitry 151 may be performed substantially close to a memory module, memory circuitry, and/or memory device of the processing element 150. As seen in FIG. 1B, the compute circuitry 151 (in the compute layer 110) may execute compute functions, and is arranged directly underneath, and is connected to, the memory bank module 116 (in the memory layer 115) in a manner that integrates (e.g., embeds) the compute capabilities physically near (e.g., proximate to memory bank module 116) and/or within (e.g., on a single die) the memory hardware of the CMS device 100. In the example of FIG. 1B, the memory bank module 116 may directly access the compute circuitry 151 that is arranged below.

Thus, due to the proximity, high-bandwidth data transfer between the memory bank module 116 and the compute circuitry 151 may be supported over the short distance in a manner that reduces latency, lowers energy consumption, and minimizes the distance relating to the transfer of data (e.g., transfer of data between memory and a separate processing unit of processing element 150). For example, the compute circuitry 151 may be configured to receive data from the memory bank module 116 and perform one or more compute functions, which can be mathematical operations that may be involved in Al and/or machine learning tasks. In one or more embodiments, the compute circuitry 151 may perform compute functions, instructions, and/or tasks, in whole and/or in part, that are related to machine learning operations, including but not limited to: matrix multiplication; dot products; activation functions used in neural networks; and/or the like. In one or more embodiments, the compute circuitry 151 may be configured to include logic to support various controller functions for the CMS device 100, such as dataflow management, scheduling operations, coordinating the transfer of data between the memory bank module 116 and other components of the processing element 150, in a manner that may increase throughput and/or reduce latency for the CMS device 100. Thus, by connecting the compute circuitry 151 to the memory bank module 116 directly using the TSVs 152 and leveraging software (e.g., opposed to global physical bus in HBM) for the transfer of data therebetween, the processing element 150 may provide a memory and an integrated, active, compute component that can significantly improve the performance and/or energy efficiency of the CMS device 100 with respect to data-intensive tasks, for example Al applications.

The TSVs 152 may be configured as high-performance interconnects between the memory layer 115 (and components therein) and the compute layer 110 (and components therein). The TSVs 152 may pass through the die 105 enabling vertical electrical connection (via) that form high-bandwidth interconnects for 3D stacked CMS dies, devices, and/or packages, as disclosed herein. In one or more embodiments, the TSVs 152 may be vertical wires that connect different layers of a microchip, and/or stacked dies, allowing for direct die-to-die communication. In one or more embodiments, the plurality of TSVs 152 may be implemented as data TSVs that are configured to carry data signals between different layers and/or die, and/or power TSVs that are configured to carry power signals and ground connections, ensuring efficient power delivery to different parts of the die or stacked dies. For example, the TSVs 152 may provide a communication connection between multiple stacked DRAM dies in the memory layer 115 and a compute die in the compute layer 110. Accordingly, the TSVs 152 may enable the short-distance and high-bandwidth data transfer between the memory bank module 116 and the compute circuitry 151 for the CMS device 100 in a manner that reduces latency and/or lowers power consumption (e.g., eliminating global data bus, eliminating the long distance and/or high-power consumption data movement from the memory stack to a SoC for compute in conventional HBMs, etc.).

The processing element 150 may be configured to include the static memory 153. The static memory 153 may be implemented, for example, as SRAM that retains data as long as power is supplied and has relatively faster access times and lower latency (e.g., relative to memory bank module 116), as deemed suitable to provide cache, and/or high-speed register capabilities for the CMS device 100. The memory 153 may be implemented as SRAM, memory cell(s), circuitry, and/or other memory components as deemed suitable and/or appropriate for operation with the compute circuitry 151. In one or more embodiments, the memory 153 is implemented as a single-ported (e.g., one data port for reading and writing at a time) SRAM.

The processing element 150 may be configured to include interconnect port(s) 154. In one or more embodiments, the interconnect ports(s) 154 may be implemented as horizontal electrical connections for ingress/egress connections to one or more other processing elements 150. For example, the processing element 150 may utilize the interconnect ports 154 as a physical connection to one or more processing elements that are positioned adjacent to processing element 150 on the die 105 in the 4 X 4 array configuration of FIG. 1A. Furthermore, arranging multiple processing elements 150 together on the die 105 may include a plurality of interconnect ports 154 that are distributed on the die 105, for example forming a "mesh" style network for communication between processing elements 150. For example, each of the processing elements 150 arranged in the 4 x 4 array on the die105 may have corresponding interconnect ports 154 which horizontally connect each processing element 150 to the one or more adjacent processing elements 150 on the die 105. The interconnect ports 154 are configured to support inter-processor connections and/or communication between the multiple processing elements 150. Thus, the plurality of interconnected processing elements 150 may collectively function as a distributed network of computing nodes, connected via the interconnect ports 154, on the die 105. In one or more embodiments, the microarchitecture of the processing element 150 may have variations in the number and/or configuration of interconnect ports(s) 154 as deemed suitable for a particular architecture of the CMS core die, device, and/or package.

As alluded to above, Al workloads may involve massive datasets and may require thousands of computations. Thus, the processing element 150 may be leveraged as a core unit that provides both memory and compute processing capabilities in a manner that is suitable or optimized for scalability and parallelism (e.g., performing multiple operations simultaneously) and ultimately enables the CMS device 100 (comprised of an array of processing elements 150) to be efficient hardware for Al applications.

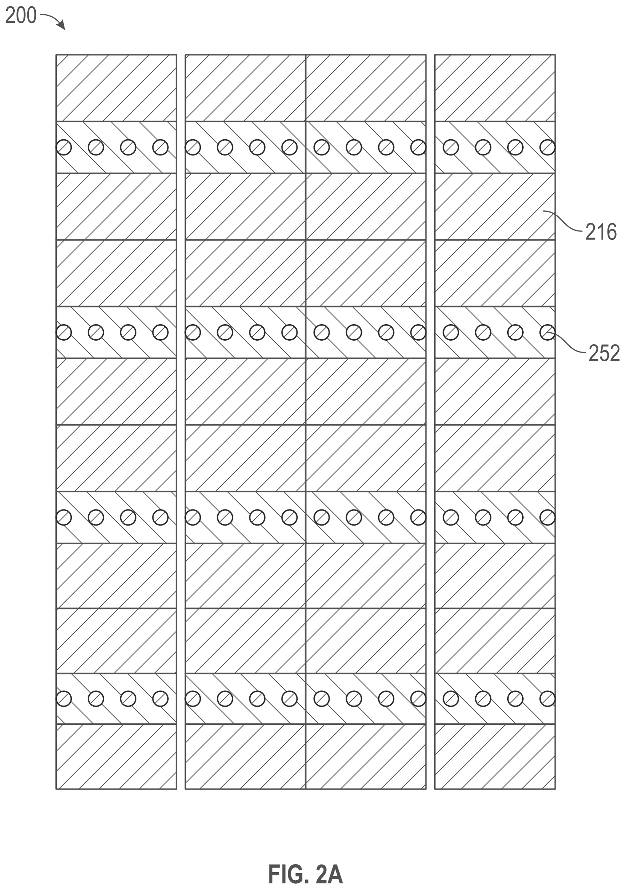

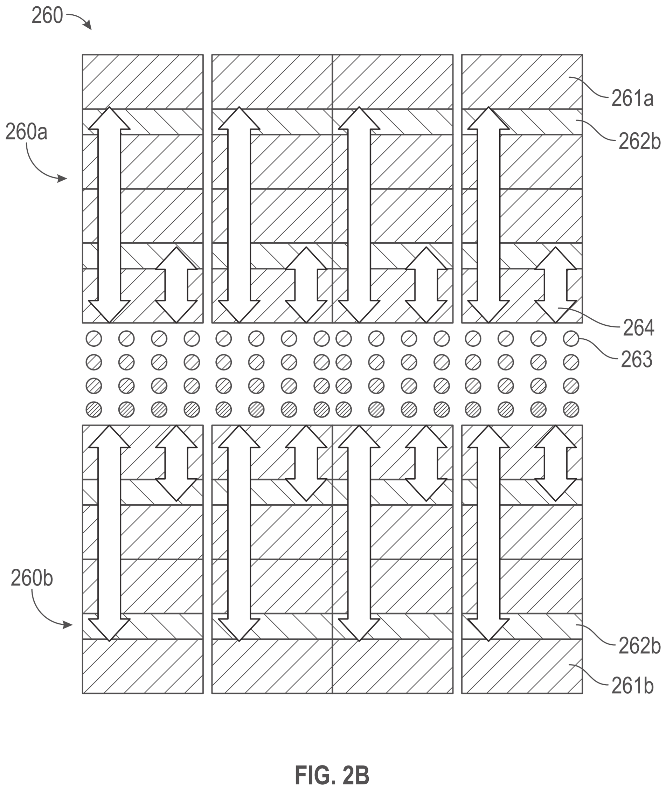

FIG. 2A is a two-dimension (2D) top view of an example CMS die 200. The architecture, components, and functions of the CMS die 200 are substantially similar to the CMS "core" die 105 as previously described above in reference to FIG. 1A and FIG. 1B. Accordingly, some details of the CMS die 200 may not be repeated in reference to FIG. 2A for purposes of brevity. FIG. 2A illustrates that the CMS die 200 may have an architecture that includes multiple stacked memory bank modules 216 with a plurality of TSVs 252 distributed therebetween. The TSVs 252 may be distributed in the CMS die 200 to implement short-distance high-bandwidth interconnections between the stacked memory bank modules 216 and the underlying compute modules in a manner that may reduce power consumption and may mitigate the need for a global physical bus and/or global addressability. In one or more embodiments, a CMS device may utilize software, in addition to, or rather than a physical bus structure (e.g., see FIG. 2B), to manage data movements among processing elements (e.g., compute, memory, etc.) in its distributed computing system (e.g., message-passing). For example, communication between multiple processing elements on a die may be controlled and/or directed by software and implemented over the physical connections between processing elements established by interconnect ports.

FIG. 2B depicts another example architecture of a CMS device 260, according to some embodiments. In one or more embodiments, the components of the CMS device 260 may be implemented on a single die. The CMS device 260 may be configured to include a first plurality of stacked memory bank modules 261a with corresponding underlying logic modules 262a, and a second plurality of stacked memory bank modules 261b with corresponding underlying logic modules 262b that are arranged on opposing regions 260a, 260b of the die. In one or more embodiments, the plurality of stacked memory bank modules 261a, 261b may be implemented as multiple stacked DRAM dies, and the logic modules 262a, 262b may be implemented as a logic dies disposed beneath the corresponding memory bank module 261a, 261b.

As seen in FIG. 2B, the first plurality of stacked memory bank modules 261a and logic modules 262a are arranged within the region 260a (e.g., near a first periphery and/or edge of the die) on one side of the die, the second plurality of stacked memory bank modules 261b and the logic modules 262b are arranged within region 260b (e.g., near a second periphery of the die) on the opposite side of the die, with a plurality of TSVs 263 positioned therebetween in a centralized location on the die. For example, the CMS device 260 may include an "on-die" host that may be configured for performing compute functions, as disclosed herein. The host may be positioned substantially near the center of the die, for instance being physically proximate to the region of the die that includes the plurality of TSVs 263 in between the two-sides of stacked memory bank modules 261a, 261b. Accordingly, the CMS device 260 may include multiple physical buses 264 to transfer data from the plurality of stacked memory bank modules 261a, 261b and logic modules 262a, 262b to the host (e.g., for compute processing) using the centrally located TSVs 263. Thus, data that may be stored in one of the first plurality of stacked memory bank modules 261a and/or logic modules 262a may have to travel the distance from region 260a to be received by the TSVs 263 in order to be transferred to the separate host for compute processing. As alluded to above, the CMS device 200 (e.g., see FIG. 2A) is configured with the TSVs distributed throughout the die and leveraging software for communication of data (e.g., message passing), in a manner that mitigates the use of a global physical bus.

FIG. 3 depicts another example of an CMS device 300 that may be configured to implement the high-bandwidth memory and compute processing capabilities, as disclosed herein. As a general description, the CMS device 300 may be described as a high-capacity variant of the CMS device 100 (e.g., see FIG. 1A), also implemented on a single die 305. The architecture, components, and functions of the CMS device 300 are substantially similar to the CMS device 100 as previously described above in reference to FIG. 1A and FIG. 1B. Accordingly, some details of the CMS device 300 may not be repeated in reference to FIG. 3 for purposes of brevity. However, FIG. 3 illustrates that the architecture of the CMS device 300 may include a 4-hi (i.e., four layer) stack configuration including a plurality of vertically stacked memory bank modules 316, rather than the "single stack" of memory bank modules 116 utilized in the CMS device 100 (e.g., see FIG. 1A). Although FIG. 3 illustrates an architecture of an CMS device 300 having four layers of vertically stacked memory bank modules, embodiments according to the present disclosure are not limited thereto, and according to some embodiments, the CMS device 300 may include a plurality of layers of vertically stacked memory bank modules that is less than, equal to, or greater than the number illustrated in FIG. 3.

As shown in FIG. 3, the CMS device 300 may be configured as a 4 x 4 array of processing elements 350. Each processing element 350 may include four memory bank modules 316 stacked on top one another in the memory layer 315, with the compute layer 310 (and components therein) disposed underneath of the 4-hi stack of memory bank modules 316. In other words, the example CMS device 300 may include a N X M (e.g., 4X4) array of processing elements 350, where each processing element 350 includes a 4-hi stack of memory bank modules 316 with a corresponding compute layer 310 beneath. Accordingly, the CMS device 300 may have an architecture that includes increased memory hardware, as compared to the CMS device 100 described in reference to FIG. 1A, thereby scaling the memory bandwidth and capacity of the CMS device 300 for increased performance and/or more complex Al applications, for example. In one or more embodiments, the 4-hi stack of memory bank modules 316 may be implemented as four stacked DRAM dies. Accordingly, in one or more embodiments, the CMS device 300 may include the 4-hi stack of a plurality of stacked DRAM dies that are further stacked on top of a logic die.

FIG. 4 depicts another example of a CMS device 400 that may be configured to implement the high-bandwidth memory and compute processing capabilities, as disclosed herein. As a general description, the CMS device 400 may be described as an increased capacity variant of the CMS device 100 (e.g., see FIG. 1A) and the CMS device 300 (e.g., see FIG. 3). The architecture, components, and functions of the CMS device 400 are substantially similar to the CMS device 100 as previously described above in reference to FIG. 1A and FIG. 1B. Accordingly, the details of the CMS device 400 are not discussed again in reference to FIG. 4 for purposes of brevity. However, FIG. 4 illustrates that the architecture of the CMS device 400 may include an 8-hi stack configuration including a plurality of eight vertically stacked memory bank modules 416, rather than the "single stack" of memory bank modules 116 utilized in the CMS device 100 (e.g., see FIG. 1A). Each processing element 450, in the 4 x 4 array of processing elements 450 of the CMS device 400, may include eight memory bank modules 416 stacked on top one another, with a corresponding compute layer 410 (and components therein) disposed underneath of the 8-hi stack of memory bank modules 316. In other words, the CMS device 400 may include a 4 x 4 array of processing elements 450, where each processing element 450 includes an 8-hi stack of memory bank modules 416 with a corresponding compute layer 410 beneath. In one or more embodiments, the 8-hi stack of memory bank modules 416 may be implemented as eight stacked DRAM dies. Accordingly, in one or more embodiments, the CMS device 400 may include the 8-hi stack of a plurality of stacked DRAM dies that are further stacked on top of a logic die.

FIG. 5 depicts another example of an CMS device 500 that may be configured to implement the high-bandwidth memory and compute processing capabilities, as disclosed herein. The architecture of the CMS device 500 may include a modular assembly of the CMS devices (e.g., 100, 300, 400). For example, the CMS device 500 may be implemented as a multi-die semiconductor package that includes a 4 x 4 array of a plurality of modularly connected CMS devices 300 (e.g., see FIG. 3) in a manner that provides a higher-level distributed computing. Each of the processing elements on a corresponding CMS device 300 may include ingress/egress inter-die ports that are configured to support horizontal electrical connections to other processing elements that may be distributed on a separate die. Thus, by arranging the multiple CMS devices 300, where each of the CMS devices 300 include a plurality of ingress/egress inter-die ports, inter-die communication is supported throughout the multi-die semiconductor package that includes the 4 x 4 array of a plurality of modularly connected CMS devices 300.

The architecture of the CMS device 500 may be configured to have each layer comprised of a single die, as shown in FIG. 5, based on the scale/size, architecture, and/or desired application of the device 500, for example. However, in one or more embodiments, the CMS device 500 may be a package including individual layers that are comprised of hardware larger than a single die, for example individual units (EG 100) that packaged together on an interposer and/or PCB, and further may have additional management/communications components in that package. Accordingly, the CMS device 500 may include multiple sub-packages that are connected within a single package, for instance including an interposer serving as a bridge for signals and power between the sub-packages and the package substrate. Each of the sub-packages in the CMS device 500 may be implemented as modular, functional circuit blocks (e.g., designed and manufactured independently) and then assembled together on the interposer, or may be packages as a sub-unit, with the sub-unit further packaged onto the interposer, and may provide several advantages compared to traditional monolithic System-on-Chips (SoCs).

The architecture, components, and functions of the individual components of CMS device 500 are the same as (or substantially similar to) the CMS device 100 as previously described above in reference to FIG. 1A and/or the CMS device 300 as previously described in reference to FIG. 3. Accordingly, some details of the CMS device 500 may not be discussed again in reference to FIG. 5 for purposes of brevity. However, FIG. 5 illustrates that the architecture of the CMS device 500 may be a larger assembly of multiple smaller CMS "core" dies (e.g., CMS device (HBMC device) 300) that are modularly repeated and connected (e.g., via ingress/egress inter-die ports) in a manner that scales the CMS device 500 to be an even higher-performance, higher-capacity variant. In some embodiments, the CMS device 500 may be implemented as a semiconductor microchip and/or semiconductor package that may include additional dies, circuitry, external components, semiconductor devices, external pins, pads, electrical connections, and/or the like that may be encased in a protective package.

Thus, the CMS die, device, and packages, as disclosed herein, may be leveraged to provide high-bandwidth memory and compute processing capabilities in a manner that can be modularly designed and scaled to be optimized based on the complexity and processing requirements of the application. For example, the CMS device 100 (e.g., see FIG. 1) may be utilized as a low-cost variant for an on-device Al-based processor, and the CMS device 500 may be utilized as a high-performance, high-capacity "super chip" variant for large scale Al-based application, such as image and speech classification.

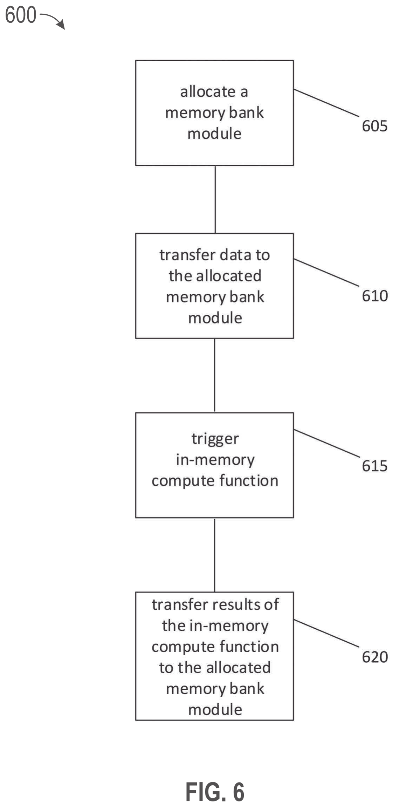

FIG. 6 is a flow chart depicting example operations of a method for transferring data within the architecture of CMS device 100 of FIG. 1A, according to some embodiments of the present disclosure. For example, FIG. 6 illustrates various operations in a method 600 that may be implemented by software to support, manage, and/or control communication, including the transfer of data, between various components in the architecture for the CMS device 100 that may be enabled through the plurality of TSVs 152 (e.g., see FIG. 1A), for example. In one or more embodiments, the software may include logic and/or instructions that are implemented by one or more components of the CMS device 100, such as the controller 121, the memory bank module 116, the compute circuity 151, the static memory 153, and/or the like. In one or more embodiments, the software may include logic and/or instructions that are implemented external to the CMS device 100, such as a host, CPU, controller, and/or the like. Although FIG. 6 illustrates various operations in a method according to some embodiments, embodiments according to the present disclosure are not limited thereto, and according to various embodiments, the method may include additional operations or fewer operations.

Furthermore, to support communication between the various components of the CMS device (HBMC device) 100 that may be involved in executing an in-memory compute function, there may be software that is utilized (e.g., replacing functions of a physical bus). In one or more embodiments, the CMS device 100 may be configured to utilize software to perform and/or execute several operations, including by not limited to: controlling data movement and/or transfer; implementing message-passing; performing data preparation and layout; performing task scheduling and synchronization; executing memory controller functions; initiating computations; managing memory layout; and/or the like.

Referring to FIG. 6 the method 600 may include one or more of the following operations. A memory bank module may be allocated (operation 605). In an operational example, the CMS device 100 may be employed by a computer device to perform a compute function that may be related to an Al application, such as multiplying two vectors. Data that may be involved in the compute function may not be initially located within the memory layer 115 of the CMS device 100. For example, data representing a vector A and vector B to be vector multiplied may be stored in a component and/or device that is external to the CMS device 100, such as CPU, main memory, GPU, and/or the like. Thus, messages and/or instructions may be communicated to the plurality of memory bank modules 116 within the memory layer 115 of the CMS device 100 to allocate at least one memory bank module 116 to be utilized for the compute function, for example allocating a memory bank module 116 to store the data during the execution of the compute function. In one or more embodiments, the messages and/or instructions may be dispatched to the plurality of memory bank modules 116 in an N x N array of processing elements 150 via the TSVs in order to allocate a selected memory bank module 116 (e.g., corresponding to a processing element 150). In one or more embodiments, allocating the memory bank module 116 may involve reserving, assigning, and/or accessing specific portions of memory within the memory bank module 116 to be used for a particular purpose or task allowing for organized and efficient use of available memory resources. Allocating the memory bank module 116 may be dynamic, where memory bank modules 116 are assigned and/or reconfigured based on changing workload requirements in some embodiments. Alternatively, the allocation may be static in one or more embodiments, where the memory bank modules 116 are pre-defined and/or assigned for a specific task.

Data may be transferred to the allocated memory bank module 116 (operation 610). Messages, instructions, and/or data may be communicated to the memory bank modules 116 within the memory layer 115 of the CMS device 100 to control the movement of the data to the allocated memory bank module 116 to be utilized for the compute function. For example, the data representing the vector A and the vector B may be transferred to the allocated memory bank module 116 (e.g., from a CPU external to the CMS device (HBMC device) 100) to store the data during the execution of the vector multiplication. In one or more embodiments, the messages and/or instructions may be dispatched to the memory bank module 116 in an N x N array of processing elements 150 via the TSVs 152 in order to transfer and/or store the data in the allocated memory bank module 116 (e.g., corresponding to a processing element 150). Accordingly, the allocation of the memory bank module 116 and/or efficient data transfer for the compute function (e.g., vector A and vector B for vector multiplication to an allocated memory bank module 116 may be synchronized and/or controlled via software (e.g., without a bus).

The compute function may be triggered (operation 615). Messages, and/or instructions may be communicated to the compute circuitry 151 that corresponds to the memory bank module 116 (e.g., for a processing element 150) to initiate and/or control the circuitry to execute the compute function. For example, the compute circuitry 151 may be configured to execute computations related to performing vector multiplication of vector A and vector B, where the data representing the vectors are stored in the memory bank module 116 during the operations. In one or more embodiments, the messages, instructions, and/or data may be communicated between the compute circuitry 151 and the corresponding memory bank module 116 via the TSVs 152. The memory bank module 116 and/or compute circuitry 151 may be configured to ensure that the processing instructions are sent to the corresponding compute circuitry 151 that are arranged underneath of the particular memory bank module 116 (e.g., on the same processing element) that stores the data relevant to those instructions. In one or more embodiments, an on-die controller (or other components) may implement the management of the transfer of data between processing elements and/or layers (on each processing element) that are arranged on the die. Accordingly, the controller and/or related software may be configured to control the communication of processing instructions to the appropriately corresponding compute circuitry 151 for the between the memory bank module 116 being utilized in the operation.

The compute circuitry 151 may execute the compute function and is disposed directly underneath the memory bank module 116. Furthermore, the compute circuitry 151 being connected to the memory bank module 116 using TSVs 151 provides a physical and communicative interconnect in a manner that may integrate the compute capabilities physically near (e.g., proximate to memory bank module 116) and/or within (e.g., on a single die) the memory hardware of the CMS device 100 to improve performance and energy efficiency (e.g., eliminate physical bus, reduce data movement, etc.). Accordingly, the execution of the compute function (e.g., vector multiplication) may be triggered, performed and/or controlled by the compute circuitry 151 via software (e.g., without a bus).

The results of the compute function may be transferred to the memory bank module (operation 620). Messages, data, and/or instructions may be communicated to the memory bank module 116 after the compute circuitry 151 executes the operations related to the compute function. For example, the compute circuitry 151 may complete the computations to generate a result of the vector multiplication of vector A and vector B. In one or more embodiments, the messages, instructions, and/or data may be communicated between the compute circuitry 151 and the corresponding memory bank module 116 via the TSVs 152 to transfer and/or store the results of the compute function in the memory bank module. Accordingly, the execution of the compute function (e.g., vector multiplication) may be performed and result obtained by the memory bank module 116 via software (e.g., without a bus) in a manner that may reduce data movement, reduces power consumption, and increases efficiency of tasks that may involve large volumes of memory access, such as Al applications.

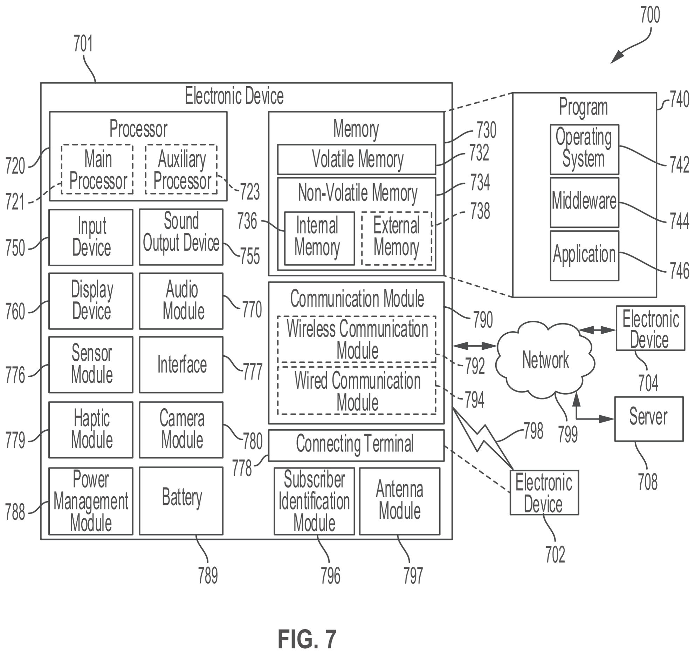

FIG. 7 is a block diagram of an electronic device, for example, implementing a parallel accelerator for Al applications utilizing the CMS device (e.g., see FIG. 1), according to some embodiments of the present disclosure. For example, the electronic device 701 may be configured to implement a generative Al application, such as an Al application that creates new content (e.g., text, images, music, videos, etc.) based on patterns learned from vast datasets. Accordingly, the processor 720 may include an accelerator processor, for instance implemented as an auxiliary processor 723 that is configured to be optimized for compute and other processing tasks related to AI. The CMS device may be physically integrated into the auxiliary processor 723 (e.g., included in the processor package) in a manner that may reduce (or minimize) latency and/or improve (or maximize) bandwidth. In some embodiments, the CMS device may be attached to and/or integrated with other components of the electronic device 701 (in addition to and/or in lieu of auxiliary processor 723), including but not limited to the main processor 721, memory 730, and the like.

As an operational example, the electronic device 701 may perform complex training processes for a large-scale model related to the generative Al application. For instance, the electronic device 701 may utilize the auxiliary processor 723 as an accelerator processor to process large matrices of input data, weights, and/or activations related to training the model(s). The auxiliary processor 723, including the CMS device, may provide transfer of data related to rapidly accessing and/or updating data during training (e.g., parameters, training data, etc.) and/or performing compute tasks related to training of the model (e.g., matrix multiplication, read/write of calculated results, etc.) with reduced delay in a manner that increases the overall performance and/or efficiency of the electronic device 701 in implementing the Al application.

Referring to FIG. 7, an electronic device 701 in a network environment 700 may communicate with an electronic device 702 via a first network 798 (e.g., a short-range wireless communication network), or with an electronic device 704 or a server 708 via a second network 799 (e.g., a long-range wireless communication network). The electronic device 701 may communicate with the electronic device 704 via the server 708. The electronic device 701 may include a processor 720, a memory 730, an input device 750, a sound output device 755, a display device 760, an audio module 770, a sensor module 776, an interface 777, a haptic module 779, a camera module 780, a power management module 788, a battery 789, a communication module 790, a subscriber identification module (SIM) card 796, and/or an antenna module 797. In one embodiment, at least one of the components (e.g., the display device 760 or the camera module 780) may be omitted from the electronic device 701, or one or more other components may be added to the electronic device 701. Some of the components may be implemented as a single integrated circuit (IC). For example, the sensor module 776 (e.g., a fingerprint sensor, an iris sensor, or an illuminance sensor) may be embedded in the display device 760 (e.g., a display).

The processor 720 may execute software (e.g., a program 740) to control at least one other component (e.g., a hardware or a software component) of the electronic device 701 coupled to the processor 720, and may perform various data processing or computations.

As at least part of the data processing or computations, the processor 720 may load a command or data received from another component (e.g., the sensor module 776 or the communication module 790) in volatile memory 732, may process the command or the data stored in the volatile memory 732, and may store resulting data in non-volatile memory 734. The processor 720 may include a main processor 721 (e.g., a central processing unit or an application processor (AP)), and an auxiliary processor 723 (e.g., a graphics processing unit (GPU), an image signal processor (ISP), a sensor hub processor, or a communication processor (CP)) that is operable independently from, or in conjunction with, the main processor 721. Additionally or alternatively, the auxiliary processor 723 may be adapted to consume less power than the main processor 721, or to execute a particular function. The auxiliary processor 723 may be implemented as being separate from, or a part of, the main processor 721.

The auxiliary processor 723 may control at least some of the functions or states related to at least one component (e.g., the display device 760, the sensor module 776, or the communication module 790), as opposed to the main processor 721 while the main processor 721 is in an inactive (e.g., sleep) state, or together with the main processor 721 while the main processor 721 is in an active state (e.g., executing an application). The auxiliary processor 723 (e.g., an image signal processor or a communication processor) may be implemented as part of another component (e.g., the camera module 780 or the communication module 790) functionally related to the auxiliary processor 723.

The memory 730 may store various data used by at least one component (e.g., the processor 720 or the sensor module 776) of the electronic device 701. The various data may include, for example, software (e.g., the program 840) and input data or output data for a command related thereto. The memory 730 may include the volatile memory 732 or the non-volatile memory 734.

The program 740 may be stored in the memory 730 as software, and may include, for example, an operating system (OS) 742, middleware 744, or an application 746.

The input device 750 may receive a command or data to be used by another component (e.g., the processor 720) of the electronic device 801, from the outside (e.g., a user) of the electronic device 701. The input device 750 may include, for example, a microphone, a mouse, or a keyboard.

The sound output device 755 may output sound signals to the outside of the electronic device 701. The sound output device 755 may include, for example, a speaker or a receiver. The speaker may be used for general purposes, such as playing multimedia or recording, and the receiver may be used for receiving an incoming call. The receiver may be implemented as separate from, or as a part of, the speaker.

The display device 760 may visually provide information to the outside (e.g., to a user) of the electronic device 701. The display device 760 may include, for example, a display, a hologram device, or a projector, and may include control circuitry to control a corresponding one of the display, hologram device, and projector. The display device 760 may include touch circuitry adapted to detect a touch, or may include sensor circuitry (e.g., a pressure sensor) adapted to measure the intensity of force incurred by the touch.

The audio module 770 may convert a sound into an electrical signal and vice versa. The audio module 770 may obtain the sound via the input device 750 or may output the sound via the sound output device 755 or a headphone of an external electronic device 702 directly (e.g., wired) or wirelessly coupled to the electronic device 701.

The sensor module 776 may detect an operational state (e.g., power or temperature) of the electronic device 701, or an environmental state (e.g., a state of a user) external to the electronic device 701. The sensor module 776 may then generate an electrical signal or data value corresponding to the detected state. The sensor module 776 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, and/or an illuminance sensor.

The interface 777 may support one or more specified protocols to be used for the electronic device 701 to be coupled to the external electronic device 702 directly (e.g., wired) or wirelessly. The interface 777 may include, for example, a high-definition multimedia interface (HDMI), a universal serial bus (USB) interface, a secure digital (SD) card interface, or an audio interface.

A connecting terminal 778 may include a connector via which the electronic device 701 may be physically connected to the external electronic device 702. The connecting terminal 778 may include, for example, an HDMI connector, a USB connector, an SD card connector, or an audio connector (e.g., a headphone connector).

The haptic module 779 may convert an electrical signal into a mechanical stimulus (e.g., a vibration or a movement) or an electrical stimulus, which may be recognized by a user via tactile sensation or kinesthetic sensation. The haptic module 779 may include, for example, a motor, a piezoelectric element, or an electrical stimulator.

The camera module 780 may capture a still image or moving images. The camera module 780 may include one or more lenses, image sensors, image signal processors, or flashes. The power management module 788 may manage power that is supplied to the electronic device 701. The power management module 788 may be implemented as at least part of, for example, a power management integrated circuit (PMIC).

The battery 789 may supply power to at least one component of the electronic device 701. The battery 789 may include, for example, a primary cell that is not rechargeable, a secondary cell that is rechargeable, or a fuel cell.

The communication module 790 may support establishing a direct (e.g., wired) communication channel or a wireless communication channel between the electronic device 701 and the external electronic device (e.g., the electronic device 702, the electronic device 704, or the server 708), and may support performing communication via the established communication channel. The communication module 790 may include one or more communication processors that are operable independently from the processor 720 (e.g., the AP), and may support a direct (e.g., wired) communication or a wireless communication. The communication module 790 may include a wireless communication module 792 (e.g., a cellular communication module, a short-range wireless communication module, or a global navigation satellite system (GNSS) communication module) or a wired communication module 794 (e.g., a local area network (LAN) communication module or a power line communication (PLC) module). A corresponding one of these communication modules may communicate with the external electronic device via the first network 798 (e.g., a short-range communication network, such as BLUETOOTHTM, wireless-fidelity (Wi-Fi) direct, or a standard of the Infrared Data Association (IrDA)), or via the second network 799 (e.g., a long-range communication network, such as a cellular network, the Internet, or a computer network (e.g., LAN or wide area network (WAN)). These various types of communication modules may be implemented as a single component (e.g., a single IC), or may be implemented as multiple components (e.g., multiple ICs) that are separate from each other. The wireless communication module 792 may identify and authenticate the electronic device 701 in a communication network, such as the first network 798 or the second network 799, using subscriber information (e.g., international mobile subscriber identity (IMSI)) stored in the subscriber identification module 796.

The antenna module 797 may transmit or receive a signal or power to or from the outside (e.g., the external electronic device) of the electronic device 701. The antenna module 797 may include one or more antennas. The communication module 790 (e.g., the wireless communication module 792) may select at least one of the one or more antennas appropriate for a communication scheme used in the communication network, such as the first network 798 or the second network 799. The signal or the power may then be transmitted or received between the communication module 790 and the external electronic device via the selected at least one antenna.

Commands or data may be transmitted or received between the electronic device 701 and the external electronic device 704 via the server 708 coupled to the second network 799. Each of the electronic devices 702 and 704 may be a device of a same type as, or a different type, from the electronic device 701. All or some of operations to be executed at the electronic device 701 may be executed at one or more of the external electronic devices 702, 704, or 708. For example, if the electronic device 701 should perform a function or a service automatically, or in response to a request from a user or another device, the electronic device 701, instead of, or in addition to, executing the function or the service, may request the one or more external electronic devices to perform at least part of the function or the service. The one or more external electronic devices receiving the request may perform the at least part of the function or the service requested, or an additional function or an additional service related to the request and transfer an outcome of the performing to the electronic device 701. The electronic device 701 may provide the outcome, with or without further processing of the outcome, as at least part of a reply to the request. To that end, cloud computing, distributed computing, or client-server computing technology may be used, for example.

Embodiments of the subject matter and the operations described in this specification may be implemented in digital electronic circuitry, or in computer software, firmware, or hardware, including the structures disclosed in this specification and their structural equivalents, or in combinations of one or more of them. Embodiments of the subject matter described in this specification may be implemented as one or more computer programs, i.e., one or more modules of computer-program instructions, encoded on computer-storage medium for execution by, or to control the operation of data-processing apparatus. Alternatively or additionally, the program instructions can be encoded on an artificially-generated propagated signal, e.g., a machine-generated electrical, optical, or electromagnetic signal, which is generated to encode information for transmission to suitable receiver apparatus for execution by a data processing apparatus. A computer-storage medium can be, or be included in, a computer-readable storage device, a computer-readable storage substrate, a random or serial-access memory array or device, or a combination thereof. Moreover, while a computer-storage medium is not a propagated signal, a computer-storage medium may be a source or destination of computer-program instructions encoded in an artificially-generated propagated signal. The computer-storage medium can also be, or be included in, one or more separate physical components or media (e.g., multiple CDs, disks, or other storage devices). Additionally, the operations described in this specification may be implemented as operations performed by a data-processing apparatus on data stored on one or more computer-readable storage devices or received from other sources.

While this specification may contain many specific implementation details, the implementation details should not be construed as limitations on the scope of any claimed subject matter, but rather be construed as descriptions of features specific to particular embodiments. Certain features that are described in this specification in the context of separate embodiments may also be implemented in combination in a single embodiment. Conversely, various features that are described in the context of a single embodiment may also be implemented in multiple embodiments separately or in any suitable subcombination. Moreover, although features may be described above as acting in certain combinations and even initially claimed as such, one or more features from a claimed combination may in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

## Claims

1. A device (100) comprising:
a first die (110), comprising:
a first compute component,
a second compute component,
a first set of Through Silicon Vias, TSVs (152), associated with the first compute component and connecting stacked dies of the device (100), and
a second set of TSVs (152) associated with the second compute component and
connecting the stacked dies of the device (100); and
a second die (115), stacked on the first die (110), comprising:
a first memory bank module connected to the first compute component using the first set of TSVs (152), and
a second memory bank module connected to the second compute component using the second set of TSVs (152).

2. The device (100) of claim 1, further comprising:
a third die, stacked on the second die (115), comprising:
a third memory bank module connected to the first compute component using the first set of TSVs (152); and
a fourth memory bank module connected to the second compute component using the second set of TSVs (152).

3. The device (100) of claim 1 or 2, wherein the first memory bank module connected to the first compute component using the first set of TSVs (152) forms a first processing element configured to perform a compute function utilizing data from the first memory bank module, and the second memory bank module connected to the second compute component using the second set of TSVs (152) forms a second processing element configured to perform a compute function utilizing data from the second memory bank module.

4. The device (100) of claim 3, further comprising a plurality of interconnected ports of the first die (110) connecting the first processing element and the second processing element to one or more additional processing elements (150), wherein the first compute component and the second compute component comprise compute circuitry (151) configured to perform the compute function and the one or more additional processing elements (150) comprise a compute component connected to at least one memory bank module from an array of memory bank modules arranged on the first die (110) stacked thereon and using corresponding sets of TSVs (152).

5. The device (100) of claim 4, wherein for the one or more additional processing elements (150), their respective compute components are configured to perform a compute function on data from their respective at least one memory bank module that is stacked thereon, and
wherein the first set of TSVs (152) and the second set of TSVs (152) are among a plurality of TSVs (152) distributed in a plurality of areas of the first die (110).

6. The device (100) of claim 5, further comprising a controller (121) programmed to execute a transfer of the data between the first compute component and the first memory bank module, a transfer of the data between the second compute component and the second memory bank module, and for the one or more additional processing elements (150), a transfer of the data between their respective compute component and their respective at least one memory bank module.

7. The device (100) of claim 5 or 6, wherein the first set of TSVs (152) comprises at least one of the plurality of TSVs (152) in a first area of the first die (110) contacting the first compute component, the second set of TSVs (152) comprises at least one of the plurality of TSVs (152) in a second area of the first die (110) contacting the second compute component.

8. The device (100) of any one of claims 3 to 7, wherein the first processing element additionally comprises the third memory bank module and is configured to perform a compute function utilizing data from the third memory bank module, and the second processing element additionally comprises the fourth memory bank module and is configured to perform a compute function utilizing data from the fourth memory bank module.

9. A system, comprising:
an accelerator processor configured for performing a compute function, the accelerator processor comprising the device (100) according to any one of claims 1 to 8; and
a memory storing instructions, the instructions to be executed by the accelerator processor to perform the compute function.

10. The system of claim 9, wherein the first memory bank module connected to the first compute component using the first set of TSVs (152) forms a first processing element configured to perform a compute function utilizing data from the first memory bank module, and the second memory bank module connected to the second compute component using the second set of TSVs (152) forms a second processing element configured to perform a compute function utilizing data from the second memory bank module.

11. The system of claim 9 or 10, wherein the stacked dies of the device (100) comprise a plurality of additional dies stacked on the second die (115).

12. The system of claim 11, further comprising Dynamic Random Access Memory, DRAM, dies, wherein one or more of the second die (115) or the plurality of additional dies comprise a DRAM die.

13. The system of claim 12, wherein the plurality of TSVs (152) are configured to transfer the data stored on the DRAM dies to the first die (110).

14. The system of any one of claims 10 to 13, further comprising a plurality of interconnect ports (154) on the first die (110) configured for connecting the first processing element and the second processing element to a plurality of processing elements to implement a distributed computing system.

15. The system of any one of claims 9 to 14, further comprising a controller (121) programmed to execute a transfer of the data between the first compute component and the first memory bank module and a transfer of the data between the second compute component and the second memory bank module.
